Europäisches Patentamt

European Patent Office

Office européen des brevets

(19)

(11) EP 0 746 100 A1

(12) EUROPÄISCHE PATENTANMELDUNG

(43) Veröffentlichungstag:
04.12.1996 Patentblatt 1996/49

(51) Int Cl.⁶: H03K 17/94

(21) Anmeldenummer: 96810335.8

(22) Anmeldetag: 24.05.1996

(84) Benannte Vertragsstaaten:
CH DE FR GB IT LI

(30) Priorität: 01.06.1995 CH 1606/95

(71) Anmelder: SENTRON AG
6300 Zug (CH)

(72) Erfinder:
• Popovic, Radivoje
6300 Zug (CH)
• Racz, Robert
6300 Zug (CH)
• Hrejsa, Jan
6300 Zug (CH)

(54) **Schaltungsanordnung zum Betrieb eines resistiven, kapazitiven oder induktiven Sensors**

(57)    Eine Schaltungsanordnung (1) zum Betrieb eines kapazitiven, induktiven oder resistiven Elementes, das als Sensor zum Erfassen des Überschreitens oder Unterschreitens eines vorbestimmten Schwellwertes dient, weist ein erstes, eine erste Zeitkonstante $\tau 1$ bestimmendes Schaltungsteil (R1, C1) und ein zweites, eine zweite Zeitkonstante $\tau 2$ bestimmendes Schaltungsteil (R2, R3, C2) auf. Die Schaltungsanordnung (1) weist weiter ein aus einer Spannungsquelle gegenüber einem Bezugspotential (m) speisbares Schaltungsteil (2) mit aktiven Bauteilen auf, die so verbunden sind, dass die Spannung am Ausgang (A) der Schaltungsanordnung (1) wechselförmig ist, sofern die Zeitkonstanten die Beziehung $\tau 1 > \tau 2$ erfüllen, und dass andernfalls die Spannung am Ausgang (A) gleichförmig ist.

**Fig. 1**

**Beschreibung**

Die Erfindung betrifft eine Schaltungsanordnung zum Betrieb eines resistiven, kapazitiven oder induktiven Sensors der im Oberbegriff des Anspruchs 1 genannten Art.

Resistive, kapazitive und induktive Sensoren stellen oft zweipolige passive elektrische Bauteile dar, deren elektrische Impedanz von einer nichtelektrischen Grösse abhängt. Temperaturabhängige Widerstände eignen sich somit als Temperatursensoren, induktive Sensoren eignen sich z.B. als Näherungs- oder Abstandssensoren. Kapazitive Sensoren dienen beispielsweise der Erfassung des Wasserstandes in einem Behälter. Solche Sensoren werden auch als Schwellwertmelder eingesetzt, die beim Überschreiten oder Unterschreiten eines vorbestimmten Schwellwertes eine bestimmte Aktion auslösen.

Der Erfindung liegt die Aufgabe zugrunde, eine einfache elektronische Schaltungsanordnung für einen Sensor vorzuschlagen, die den Sensor betreibt, den vom Sensor erfassten Messwert mit einem Referenzwert vergleicht und ein einfach verarbeitbares und/oder interpretierbares Ausgangssignal erzeugt.

Die genannte Aufgabe wird erfindungsgemäss gelöst durch die Merkmale der Ansprüche 1, 7, 8 und 9. Vorteilhafte Ausgestaltungen ergeben sich aus den abhängigen Ansprüchen.

Gemäss der Erfindung werden verschiedene Funktionen, die zum Betrieb eines als Schwellwertmelder eingesetzten zweipoligen elektrischen Sensors und zur Aufbereitung des vom Sensor gelieferten Messwertes in ein einfach interpretierbares Ausgangssignal notwendig sind, mit einem Minimum an aktiven elektronischen Bauteilen verwirklicht, indem der Sensor die Schwingungsbedingungen einer schwingfähigen Schaltungsanordnung steuert. Die schwingfähigen Schaltungsanordnungen beruhen bevorzugt auf dem Prinzip der Relaxationsoszillatoren, bei denen ein kapazitives oder induktives Element laufend aufgeladen und entladen wird und dabei ein wechselförmiges Signal erzeugt. Solche schwingfähige Schaltungsanordnungen sind der Fachwelt unter verschiedenen Namen bekannt, die sich aus dem näheren Zweck der Schaltungsanordnung ergeben, z.B. als Relaxationsoszillatoren, Multivibratoren, Kippstufen, etc.. Der Hauptaspekt der Erfindung liegt darin, eine solche schwingfähige Schaltung mit einem weiteren kapazitiven oder induktiven Element zu versehen, das einen vorbestimmten Einfluss auf die Oszillationen ausübt. Nachfolgend werden ausgewählte Ausführungsbeispiele der Erfindung anhand der Zeichnung näher erläutert. Anhand dieser Ausführungsbeispiele lassen sich auf dem gleichen Prinzip basierende Schaltungsanordnungen finden.

Es zeigen:

Figur 1    eine Schaltungsanordnung mit einem Komparator zum Betrieb eines resistiven oder kapazitiven Sensors,

Figur 2    Spannungsdiagramme,

Figur 3    eine Schaltungsanordnung zum Betrieb eines induktiven Sensors,

Figur 4    ein Schaltungsteil zur Gleichrichtung einer wechselförmigen Spannung,

Figur 5    eine Schaltungsanordnung mit zwei als Schmitt-Trigger geschalteten Transistoren zum Betrieb eines kapazitiven Sensors,

Figur 6    eine Schaltungsanordnung mit zwei Invertern zum Betrieb eines kapazitiven Sensors,

Figur 7    ein vereinfachtes Schaltbild der Schaltungsanordnung der Figur 6,

Figur 8    ein Spannungsdiagramm,

Figur 9    eine Schaltungsanordnung zum Betrieb eines resistiven Sensors und

Figur 10   einen Flüssigkeitsbehälter mit zwei kapazitiven Wasserstandssensoren.

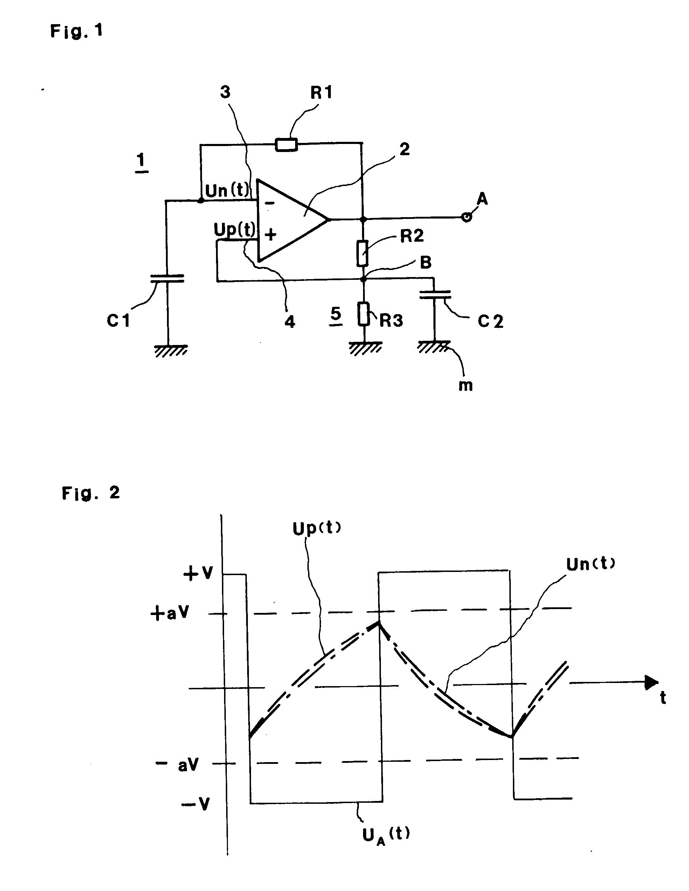

Die Figur 1 zeigt eine schwingfähige Schaltungsanordnung 1 mit einem Ausgang A. Die Schaltungsanordnung 1 weist einen Komparator 2 mit einem invertierenden Eingang 3, einem nicht invertierenden Eingang 4 und einem Ausgang sowie einen Spannungsteiler 5 auf. Der Ausgang des Komparators 2 bildet den Ausgang A der Schaltungsanordnung 1. Der Komparator 2 ist auf bekannte, nicht dargestellte Art gegenüber einem Bezugspunkt m bipolar gespeist und stellt somit ein aktives elektronisches Bauelement dar. Der Ausgang A ist über den durch zwei in Reihe geschaltete Widerstände R2 und R3 gebildeten Spannungsteiler 5 mit dem Bezugspunkt m verbunden. Der Mittenabgriff B des Spannungsteilers 5 ist mit dem nicht invertierenden Eingang 4 verbunden. Der Ausgang A ist über einen Widerstand R1 mit dem invertierenden Eingang 3 verbunden. Weiter ist der invertierende Eingang 3 über ein erstes kapazitives Element C1 mit dem Bezugspunkt m verbunden. Ein zweites kapazitives Element C2 verbindet den Mittenabgriff B des Spannungsteilers 5 mit dem Bezugspunkt m. In der Regel stellt eines der Elemente C1, C2, R1, R2, R3 einen Sensor und die anderen Referenzelemente dar.

Ohne das kapazitive Element C2 verhält sich die Schaltungsanordnung 1 im Betrieb als ein astabiler Multivibrator: Die Spannung $U_A(t)$ am Ausgang A ist wegen der hohen Spannungsverstärkung des Komparators 2 eine oszillierende Rechteckspannung, deren Frequenz f durch die Beziehung

$$f = \frac{1}{2*R1*C1*\ln(1+\frac{2*R2}{R3})}$$

gegeben ist. Die Frequenz f ist also indirekt proportional zum Wert des kapazitiven Elementes C1. Die Arbeitsweise der Schaltungsanordnung 1 ist im Idealfall folgende: Die Spannung $U_A(t)$ am Ausgang A nimmt einen festen, vorgegebenen Wert +V an, wenn die Spannung Un(t) am invertierenden Eingang 3 kleiner als die Spannung Up(t) am nicht invertierenden Eingang 4 ist, sie nimmt den festen Wert -V an, wenn die Spannung Un(t) grösser als die Spannung Up(t) ist. Die Spannung Up(t) ist dank des ohmschen Spannungsteilers 5 proportional zur Spannung $U_A(t)$: Up(t)=a*$U_A$(t), wobei die Grösse a durch die Widerstände R2 und R3 bestimmt ist zu

$$a = \frac{R3}{R2+R3} \ .$$

Die Grösse a ist somit eine positive Konstante mit einem Wert kleiner als Eins. Die Spannung Up(t) kann demzufolge nur die zwei festen Werte -a*V und +a*V annehmen. Die Spannung $U_A(t)$=+V bewirkt das Laden des kapazitiven Elementes C1 über den Widerstand Rl und damit eine Zunahme der Spannung Un(t). Die Spannung Un(t) könnte maximal den Wert +V erreichen. Sobald die Spannung Un(t) jedoch den Wert Up(t)=+a*V überschreitet, wechselt die Spannung $U_A(t)$ vom Wert +V auf den Wert -V, so dass sich das kapazitive Element Cl wieder entlädt und die Spannung Un(t) wieder abnimmt. Sobald die Spannung Un(t), die jetzt den minimalen Wert -V erreichen könnte, den Wert Up(t) =-a*V unterschreitet, wechselt die Spannung $U_A(t)$ wieder vom Wert -V auf den Wert +V: Die Schaltungsanordnung 1 schwingt.

Mit dem kapazitiven Element C2 springt der Wert der Spannung Up(t) bei einem Sprung der Spannung $U_A(t)$ von +V nach -V oder von -V nach +V nicht mehr schlagartig von +a*V nach -a*V bzw. von -a*V nach +a*V. Die Arbeitsweise der Schaltungsanordnung ist nun die, dass bei positiver Spannung $U_A(t)$=+V auch das kapazitive Element C2 aufgeladen wird und dass bei negativer Spannung $U_A(t)$=-V das kapazitive Element C2 wieder teilweise entladen wird. Die Schaltungsanordnung 1 schwingt, sofern die Bedingung

$$\tau 1 > \frac{1}{a} \tau 2 \ ,$$

d.h. **R1*C1 > R2*C2** erfüllt ist. Gilt die Beziehung

$$\tau 1 \leq \frac{1}{a} \tau 2 \ ,$$

dann ist die Spannung $U_A(t)$ konstant und gleich dem Wert des Potentials am Bezugspunkt m.

Die Figur 2 zeigt den zeitlichen Verlauf der Spannungen Un(t), Up(t) und $U_A(t)$ für den Fall, dass die Zeitkonstante τ1 grösser als die Zeitkonstante τ2 ist. Dabei bezeichnet t die Zeit. Bei einem Wechsel der Spannung $U_A(t)$ vom Wert +V auf den Wert -V, sind die beiden Spannungen Un(t) und Up(t) gerade gleich gross und gleich dem Wert $-V_1$. Jetzt beginnt das Laden der beiden kapazitiven Elemente Cl und C2 und die Spannungen Un(t) und Up(t) nehmen zu. Die Spannung Un(t) nimmt exponentiell mit der Zeitkonstanten τ1 zu und würde beim Ausbleiben eines weiteren Spannungswechsels am Ausgang A asymptotisch den Wert +V erreichen. Die Spannung Up(t) nimmt exponentiell mit der Zeitkonstanten τ2 zu und würde beim Ausbleiben eines weiteren Spannungswechsels am Ausgang A asymptotisch den Wert +a*V erreichen. Wie aus der Figur 2 ersichtlich ist, kreuzen sich somit die beiden Spannungskurven Un(t) und Up(t) wieder, wobei dann wegen des Vorzeichenwechsels der Spannungsdifferenz Un(t)-Up(t) am Eingang des Komparators 2 (Figur 1) die Ausgangsspannung $U_A(t)$ vom Wert -V auf den Wert +V springt. Dann beginnt analog das Entladen der kapazitiven Elemente C1 und C2: Die Schaltungsanordnung 1 schwingt. Falls die Beziehung

$$\tau 1 \leq \frac{1}{a} \tau 2 \ ,$$

gilt, dann führt der Ausgang A das Potential m.

Die Frequenz f, mit der die Schaltungsanordnung 1 schwingt, ist nicht mehr abhängig von einer einzigen Zeitkonstanten τ1, sondern von der Differenz der zwei Zeitkonstanten τ1 und τ2. Der Widerstand R1 und das kapazitive Element C1 stellen ein erstes Schaltungsteil in der Form eines RC-Gliedes dar, das die Zeitkonstante τ1 bestimmt. Die Widerstände R2, R3 und das kapazitive Element C2 stellen ein zweites als RC-Glied ausgebildetes Schaltungsteil dar, das die Zeitkonstante τ2 bestimmt, wobei bei diesem Beispiel die Widerstände R1 und R2 als zwei parallel angeordnete Widerstände mit dem Wert

$$r = \frac{R2 * R3}{R2 + R3}$$

angesehen werden können. Die Schaltungsanordnung 1 arbeitet in Bezug auf die beiden RC-Glieder nicht symmetrisch, da Schwingungen nur möglich sind, wenn die Bedingung **R1∗C1** > **R2∗C2** erfüllt ist.

Die Spannung $U_A(t)$ am Ausgang A der Schaltungsanordnung 1 ist somit entweder eine wechselförmige oder eine gleichförmige Spannung. Falls das kapazitive Element C1 als Sensor und das kapazitive Element C2 als Referenzelement eingesetzt ist, dann wechselt die Signalform von wechselförmig auf gleichförmig, wenn der Wert des Sensorelementes C1 einen vorgegebenen Schwellwert Cw unterschreitet. Der Wert Cw bestimmt sich aufgrund der Beziehung a*τ1 = τ2 zu

$$Cw = \frac{R2}{R1} * C2.$$

Falls das kapazitive Element C2 als Sensor und das kapazitive Element C1 als Referenzelement dient, dann ist die Ausgangsspannung $U_A(t)$ konstant, wenn der Messwert des Sensors C2 den Wert

$$Cv = \frac{R1}{R2} * C1$$

überschreitet.

Die Schaltungsanordnung 1 integriert somit die Funktionen Erregen des kapazitiven Sensors, Erfassen des Messwertes des kapazitiven Sensors, Vergleich mit einem vorbestimmten Wert und Abgabe einer konstanten Ausgangsspannung, wenn der Messwert den vorbestimmten Wert unterschreitet bzw. überschreitet, mit einem einzigen aktiven elektronischen Bauteil, dem Komparator 2.

Da die Schaltungsanordnung 1 zwei Zeitkonstanten vergleicht, lässt sie sich ohne Änderungen auch verwenden, wenn einer der Widerstände R1, R2 oder R3 als Sensor eingesetzt ist und das Überschreiten oder Unterschreiten eines Schwellwertes zu erfassen ist. Einzig die Werte der Bauteile sind den erforderlichen Gegebenheiten anzupassen.

Die Schaltungsanordnung 1 lässt sich auf einfache Weise verändern, um einen induktiven Sensor auf analoge Art zu betreiben. Bei einer ersten Ausführung ist der Widerstand R1 durch eine Spule L1 und das kapazitive Element C1 durch einen Widerstand R4 ersetzt. Die Spule L1 und der Widerstand R4 bilden als LR-Glied ein Schaltungsteil, dessen Zeitkonstante τ1=L1/R4 mit der unveränderten Zeitkonstanten τ2 das Verhalten der Schaltungsanordnung bestimmt. Die Schaltungsanordnung schwingt in diesem Fall, sofern die Bedingung **L1** > **R2∗R4∗C2** erfüllt ist. Andernfalls führt der Ausgang eine Spannung $U_A(t)$, die gleich dem Potential des Bezugspunktes m ist.

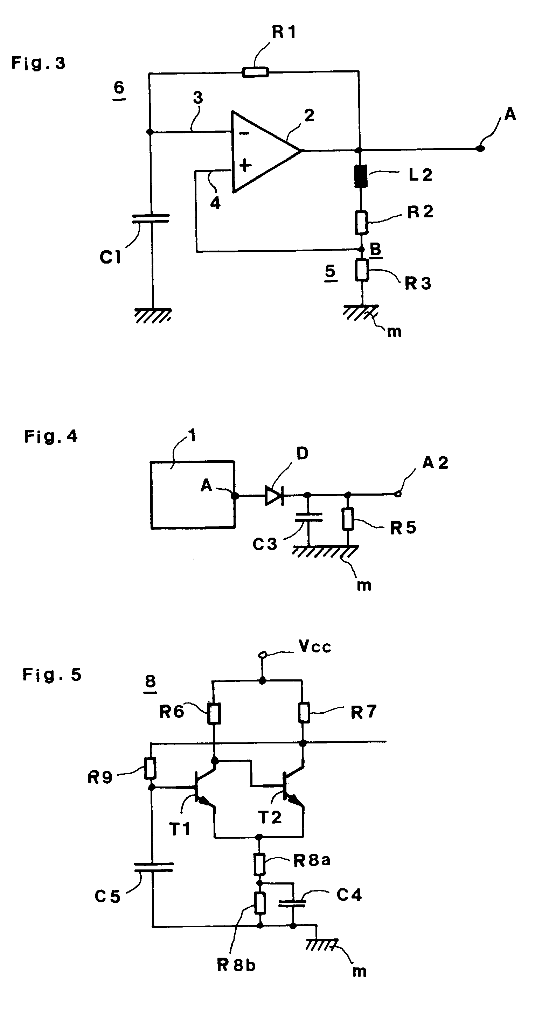

Die Figur 3 zeigt in einer weiteren Ausführung eine Schaltungsanordnung 6, bei der das kapazitive Element C2 ersetzt ist durch eine Spule L2, die zwischen den Ausgang A und den ersten Widerstand R2 des Spannungsteilers 5 geschaltet ist. In diesem Fall hat die Zeitkonstante τ2 den Wert L2/(R2+R3). Die Schaltungsanordnung 6 schwingt demnach, sofern die Beziehung L2 < R1*R3*C1 erfüllt ist.

Andernfalls liefert sie eine konstante Ausgangsspannung $U_A(t)$.

Alle diese Beispiele sind in dem Sinne ähnlich, dass das Verhalten der Schaltungsanordnungen 1 und 6 von zwei Zeitkonstanten τ1 und τ2 abhängt, wobei die Zeitkonstanten τ1 und τ2 jeweils durch ein Schaltungsteil in der Form eines RC-Gliedes (R1, C1; r, C2) oder eines LR-Gliedes (L1, R4; L2, R2+R3) bestimmt sind. Der Schwellwert, bei dem die Signalform am Ausgang A von der wechselförmigen auf die gleichförmige Form wechselt, ist durch die Parameter der anderen Bauteile der die Zeitkonstanten τ1 und τ2 bestimmenden RC-und/oder LR-Glieder bestimmt.

Ob ein kapazitiver, induktiver oder resistiver Sensor die Zeitkonstante τ1 oder τ2 verändern soll, hängt davon ab, welche Ausgangsspannung $U_A(t)$ beim Überschreiten des vorbestimmten Schwellwertes vorhanden sein soll, eine gleichförmige mit dem Potential des Bezugspunktes m oder eine wechselförmige. Die wechselförmige Spannung $U_A(t)$ kann bei Bedarf auf einfache Weise in eine gleichförmige Spannung $U_{A2}(t)$ mit einem vom Potential des Bezugspunktes m leicht unterscheidbaren Wert umgewandelt werden, in dem dem Ausgang A, wie in der Figur 4 gezeigt, eine gleichrichtende Diode D, ein Kondensator C3 und ein Widerstand R5 nachgeschaltet sind.

Falls die Schaltungsanordnung 1 Teil einer Einrichtung mit einem Mikroprozessor ist, wobei zum Zweck der Feststellung des Zustandes der Schaltungsanordnung 1 deren Ausgang A mit dem Eingang des Mikroprozessors verbindbar ist, dann kann auch anstelle eines in der Figur 4 gezeigten Schaltungsteils der Mikroprozessor dahingehend programmiert sein, während einer vorbestimmten Zeitdauer die Spannung $U_A(t)$ am Ausgang A als eine Folge fl von Spannungswerten wiederholt zu erfassen und die Folge fl anschliessend zu analysieren, ob sie einen wechselförmigen oder gleichförmigen Spannungsverlauf darstellt. Dabei ist es bevorzugt, dass die Folge fl entsprechend einem vorgegebenen Spannungspegel eine Folge binär digitalisierter Werte der Spannung $U_A(t)$ ist.

Die in den Schaltungsanordnungen 1 und 6 (Figur 1 bzw. 3) enthaltenen Widerstände R1 und R2 können durch Stromquellen ersetzt werden, die vom Ausgang des Komparators 2 gesteuert sind. Dabei wird der zeitliche Verlauf der Spannungen Un(t) und Up(t) bei den Umladevorgängen linearisiert. Die Verwendung gesteuerter Stromquellen bietet Vorteile bei der Integration der Schaltungsanordnung 1 bzw. 6 auf einem einzigen Chip. Alternativ ist es auch möglich, den Komparator 2 und die beiden Widerstände R1 und R2 durch einen sogenannten Operational Transconductance Amplifier (OTA) zu ersetzen.

Die Figur 5 zeigt eine dritte Schaltungsanordnung 8, bei der anstelle des Komparators 2 (Figur 1) zwei Transistoren T1 und T2 vorhanden sind, die ebenfalls aktive Bauelemente darstellen. Der Kollektor des ersten Transistors TI ist über einen Widerstand R6, der Kollektor des zweiten Transistors T2 über einen Widerstand R7 mit einem Potential $V_{CC}$ verbunden. Der Kollektor des Transistors T1 ist weiter mit der Basis des Transistors T2 verbunden. Die Emitter beider Transistoren T1, T2 sind miteinander und über zwei in Reihe geschaltete Widerstände R8a und R8b mit einem Massepunkt m verbunden. Dem Widerstand R8b ist ein kapazitives Element C4 parallel geschaltet. Der Basiseingang des Transistors T1 ist über ein kapazitives Element C5 mit dem Massepunkt m und über einen Widerstand R9 mit dem Kollektor des zweiten Transistors T2 verbunden. Der Kollektor des Transistors T2 bildet einen Ausgang A der Schaltungsanordnung 8. Die Schaltungsanordnung 8 ist somit von der Spannung $V_{CC}$ unipolar gegen Masse m gespeist. Wie aus der Figur 5 ersichtlich ist, ist die Basis des zweiten Transistors T2 mit dem Kollektor des ersten Transistors gekoppelt. Bei diesem Beispiel ist die Kopplung direkt.

Die beiden Transistoren T1, T2 und die Widerstände R6, R7, R8a und R8b bilden einen emittergekoppelten Schmitt-Trigger, dessen Funktionsweise beispielsweise dem Buch "Microelectronics", J. Millman und A. Grabel, McGraw-Hill Book Company, 2. Auflage, S. 682-683 (ISBN 0-07-042330-X) entnommen werden kann.

Die Arbeitsweise der Schaltungsanordnung 8 ist ähnlich der anhand der Figur 1 beschriebenen Schaltungsanordnung 1. Ein wesentlicher Unterschied besteht jedoch darin, dass die Schaltungsanordnung 8 unipolar gespeist ist.

Da die bisher beschriebenen Schaltungsanordnungen zwei Zeitkonstanten vergleichen, die durch RC- und/oder LR-Glieder bestimmt sind, lässt sich der genaue Schwellwert, z.B. Cw, dadurch einstellen, dass wenigstens einer der in den RC- und/oder LR-Glieder vorkommenden Widerstände R trimmbar ist. Weiter ist auch die Kompensation einer Temperaturabhängigkeit des als Sensor dienenden kapazitiven oder induktiven Elementes C bzw. L möglich, indem wenigstens einer der Widerstände einen dem Rechnung tragenden Temperaturkoeffizienten aufweist.

Die Schaltungsanordnungen 1, 6 und 8 (Figuren 1, 3, 5) können gemäss einer Weiterbildung der Erfindung auch eingesetzt werden zur Messung von kleinen Differenzen zwischen den Zeitkonstanten $\tau1$ und $\tau2$, indem ein dem Ausgang A nachgeschaltetes Schaltungsteil, z.B. ein Zählbaustein zur Zählung von Impulsen oder ein Mikroprozessor, etc. die Frequenz der Spannung $U_A(t)$ bestimmt. Eine Anwendung besteht darin, dass z.B. zwei ähnliche kapazitive Elemente C1 und C2 (Figur 1) oder zwei ähnliche induktive Sensoren vorgesehen sind, die örtlich versetzt angeordnet sind, um einen auf einer Gradientenmessung bildenden Näherungssensor für einen, z.B. dielektrischen, metallenen oder magnetischen Gegenstand zu bilden. Die beiden Sensoren werden dabei unterschiedlich beeinflusst, so dass sich die Zeitkonstanten $\tau1$ und $\tau2$ ein wenig unterscheiden. Die Frequenz der Spannung $U_A(t)$ ist bei entsprechender Wahl der zugeordneten Widerstände R1, R2 und R3 (Figur 1) ein hochempfindliches Mass für diese Differenzen. Die Widerstände R1, R2 und R3 sind so festzulegen, dass die Zeitkonstante $\tau1$ und die Grösse $\tau2/a$ bei Abwesenheit des zu erkennenden Gegenstandes etwa gleich gross sind. Wichtig ist einzig die Einhaltung der Schwingungsbedingung, dass die Zeitkonstante $\tau1$ grösser als die Grösse $\tau2/a$ ist. Da bei der Annäherung eines Gegenstandes beide Sensoren ihren Wert ändern, sind kleine Unterschiede detektierbar, wobei sich die Schaltungsanordnung selbsttätig reguliert, indem sie nur auf Differenzen einer physikalischen Grösse anspricht. Beispielsweise ist so das Profil eines Gegenstandes oder der Gradient einer seiner Eigenschaften messbar.

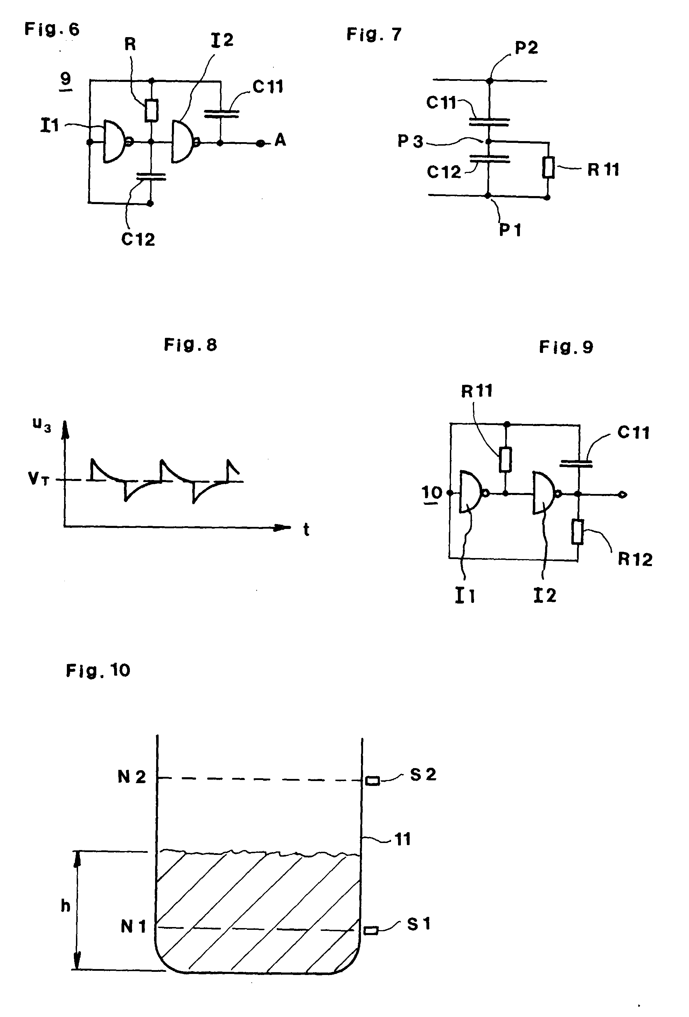

Die Figur 6 zeigt eine mit zwei Invertern I1 und I2 gebildete, schwingfähige Schaltungsanordnung 9, die geeignet ist als Schaltung für einen kapazitiven Sensor, der als Schwellwertmelder dient. Der Ausgang des ersten Inverters I1 ist mit dem Eingang des zweiten Inverters I2 verbunden. Der Ausgang des Inverters I2 ist über ein kapazitives Element C11 mit dem Eingang des Inverters I1 verbunden. Eingang und Ausgang des ersten Inverters I1 sind erstens über einen Widerstand R11 und zweitens über ein kapazitives Element C12 miteinander verbunden. Das kapazitive Element C12 und der Widerstand RII bilden ein RC-Glied, dessen Zeitkonstante die Frequenz der Schaltungsanordnung 9 mitbestimmt. Die Inverter I1 und I2 sind unipolar gespeist und führen an ihrem Ausgang entweder eine Spannung U=0 oder eine Spannung $U=U_o$. Ohne das kapazitive Element C12 bildet die Schaltungsanordnung einen bekannten astabilen Multivibrator, der nach dem Prinzip eines Relaxationsoszillators arbeitet. Eine Beschreibung ist z.B. im Abschnitt über Kippschaltungen im Buch "Halbleiterschaltungstechnik", U. Tietze und Ch. Schenk, Springer Verlag, 10. Auflage, Seite 185 ff. zu finden.

Die Arbeitsweise der Schaltungsanordnung 9 lässt sich anhand der Figur 7 verstehen, die nur die passiven Elemente C11, C12 und R11 der Figur 6 zeigt. Die Spannung ul am Punkt P1 ist gleich der Spannung am Ausgang des ersten Inverters I1, die Spannung u2 am Punkt P2 ist gleich der Spannung am Ausgang des zweiten Inverters I2. Dabei bestimmt die Spannung u3 am Punkt P3 die Spannungen u1 und u2. Es sind zwei Zustände A und B zu unterscheiden:

Im Zustand A ist die Spannung u3 kleiner als die Schaltspannung $V_T$ des Inverters I1 und es gilt für die Spannungen ul und u2: u1=0 und u2=$U_o$. Im Zustand B ist die Spannung u3 grösser als die Schaltspannung $V_T$ und es gilt u1=$U_O$ und u2=0. Bei einem Wechsel der Spannungen u1 und u2 an den Ausgängen verhalten sich die beiden kapazitiven Elemente C11 und C12 als ein kapazitiver Spannungsteiler und die Spannung u3 stellt sich den Zuständen A und B entsprechend als

$$u3_A(t=0)=\frac{C11}{C11+C12}*U_0 \text{ bzw. } u3_B(t=0)=\frac{C12}{C11+C12}*U_0$$

ein. Anschliessend wird das Element C12 über den Widerstand R11 auf die Spannung U=0 entladen bzw. auf die Spannung U=$U_o$ aufgeladen, wobei der zeitliche Verlauf der Spannung u3(t) exponentiell erfolgt:

$$u3_A(t)=\frac{C11}{C11+C12}*e^{-\frac{t}{R11*C12}}*U_0 \text{ bzw. } u3_B(t)=(1-\frac{C11}{C11+C12}*e^{-\frac{t}{R11*C12}})*U_0.$$

Die Zeitachse t ist in den Gleichungen so festgelegt, dass bei jedem Kippen der Schaltungsanordnung 9 t=0 ist. Solange nun die Spannung u3(t) kleiner als die Schaltspannung $V_T$ ist, nimmt die Schaltungsanordnung 9 den Zustand A ein, solange die Spannung u3(t) grösser als die Schaltspannung $V_T$ ist, nimmt die Schaltungsanordnung 9 den Zustand B ein. Es gibt nun zwei Möglichkeiten: Falls die Schaltungsanordnung 9 vom Zustand B in den Zustand A kippt und daraufhin der Wert der Spannung u3$_A$(t=0) zum Kipppunkt t=0 kleiner als die Schaltspannung $V_T$ ist, dann kippt die Schaltungsanordnung 9 sofort wieder in den Zustand B. Ist nun im Zustand B die Spannung u3$_B$(t=0) unmittelbar nach dem Kippen grösser als die Schaltspannung $V_T$, dann kippt die Schaltungsanordnung 9 wieder in den Zustand A. Es ist somit keiner der Zustände A und B stabil. Wären die Inverter I1 und I2 ideale Schalter, deren Ausgang entweder das Potential 0 oder das Potential $U_O$ annimmt, dann wäre die Spannung u2 am Ausgang des Inverters I2 eine mit sehr hoher Frequenz oszillierende. Da die Inverter I1 und I2 keine idealen Schalter sind und da beim ständigen Umschalten zwischen den beiden Zuständen A und B das kapazitive Element C12 nicht mehr über den Widerstand R11 umgeladen wird, fliesst über den Widerstand RII auch kein Strom mehr. Die Spannungen ul und u2 nehmen deshalb den Wert $V_T$ an.

Die andere Möglichkeit besteht nun darin, dass nach dem Kippen vom Zustand B in den Zustand A die Spannung u3$_A$(t) für eine gewisse Zeitspanne grösser als die Schaltspannung $V_T$ ist. Da die Spannung u3$_A$(t) im Zustand A exponentiell gegen den Wert 0 strebt, wird die Spannung u3$_A$(t) die Schaltspannung $V_T$ wieder unterschreiten, so dass die Schaltungsanordnung 9 in den Zustand B kippt. Im Zustand B strebt die Spannung u3$_B$(t) jedoch gegen den Wert $U_o$, so dass die Schaltungsanordnung 9 nach einer gewissen Zeitspanne wieder in den Zustand A kippt: Die Schaltungsanordnung 9 schwingt. Die Frequenz der Schwingungen hängt ab von den Werten der kapazitiven Elemente C11 und C12, dem Wert des Widerstandes R11 und der Höhe der Schaltspannung $V_T$. Der zeitliche Verlauf der Spannung u3(t) am Eingang des Inverters I1 ist für einen solchen Fall in der Figur 8 dargestellt. Falls das kapazitive Element C11 als Sensor und das kapazitive Element C12 als Referenzelement dient, schwingt die Schaltungsanordnung 9, sobald der Messwert des Sensors C11 den Schwellwert

$$C_{T1} = \frac{V_T}{V-V_T}*C12$$

überschreitet. Dient das kapazitive Element C12 als Sensor und das kapazitive Element CII als Referenzelement, dann schwingt die Schaltungsanordnung 9, sobald der Messwert des Sensors C12 den vorbestimmten Schwellwert

$$C_{T2} = \frac{V-V_T}{V_T}*C11$$

unterschreitet. Die Schaltungsanordnung 9 dient also dazu, die Werte der beiden kapazitiven Elemente C11 und C12 zu vergleichen und ein Schwellwertsignal zu bilden.

Der durch die Elemente C11 und C12 gebildete kapazitive Spannungsteiler erfüllt die wichtige Funktion, dass die Spannung u3, die am Punkt P3 zwischen den beiden kapazitiven Elementen CII und C12 herrscht, bei jedem Wechsel vom Zustand A in den Zustand B oder umgekehrt sprunghaft ändert. Dieser sprunghafte Spannungswechsel und das anschliessende Ändern der Spannung u3 in Richtung der Schaltspannung $V_T$ ermöglichen zusammen die Ausbildung von Schwingungen. Schwingungen treten dann nicht auf, wenn die Differenz zwischen der Spannung u3 und der Schaltspannung $V_T$ nach dem sprunghaften Wechsel zunimmt.

Die Figur 9 zeigt eine Schaltungsanordnung 10, bei der das kapazitive Element C12 weggelassen ist. Zwischen den Ausgang des Inverters I2 und den Eingang des Inverters I1 ist dafür ein Widerstand R12 geschaltet. Die Schaltungsanordnung 10 ist geeignet zum Vergleich der beiden Widerstände RII und R12 und zur Bildung eines Schwellwertsignales. Die Schaltungsanordnung 10 führt am Ausgang A des Inverters I2 ein Potential mit dem Wert 0 oder mit dem Wert $U_o$, falls die Beziehung

$$\frac{R11}{R11+R12} * U_0 < V_T$$

erfüllt ist, andernfalls führt sie das Potential $V_T$.

Die Schaltungsanordnungen 9 und 10 lassen sich auch kombinieren zu einer Schaltungsanordnung, die sowohl die beiden kapazitiven Elemente C11, C12 wie auch die beiden Widerstände R11 und R12 umfasst. Die Schwingungsbedingungen und das Potential am Ausgang des Inverters I2 in Funktion der Werte C11, C12, R11, R12 und $V_T$ lassen sich analysieren, indem die Differentialgleichungen für die Ströme und Spannungen im Zustand A und im Zustand B gelöst und die Schwingungsbedingungen analog der vorgängig skizzierten Betrachtung beachtet werden. Im Zustand A verläuft die Spannung $u3_A(t)$ dann gemäss der Formel

$$u3_A(t) = \left(\frac{C12}{C11+C12} - \frac{R11}{R11+R12}\right) * V * e^{-\frac{R11+R12}{R11*R12} * \frac{1}{C11+C12} * t} + \frac{R11}{R11+R12} * V \quad \cdot$$

Die Spannung $u3_B(t)$ ergibt sich durch Vertauschen der Indizes 1 und 2.

Aus der Äquivalenz der RC und LR Glieder ergibt sich die Möglichkeit, bei diesen Schaltungsanordnungen jeweils wenigstens ein RC-Glied durch ein LR-Glied zu ersetzen, indem das kapazitive Element C durch einen Widerstand R und der Widerstand R durch eine Spule L ersetzt wird.

Die Figur 10 zeigt ein Anwendungsbeispiel für zwei kapazitive Sensoren S1 und S2, die sich beispielsweise mit der Schaltungsanordnung 9 (Figur 6) betreiben lassen. Die Sensoren S1 und S2 dienen dazu, den Füllstand eines Flüssigkeitsbehälters 11 bezüglich eines unteren und oberen Niveaus N1 bzw. N2 zu überprüfen. Der Sensor S1 stellt das kapazitive Element C11 und der Sensor S2 das kapazitive Element C12 der Schaltungsanordnung 9 dar. Die Sensoren S1 und S2 sind aufgrund ihrer physikalischen und geometrischen Eigenschaften so gewählt, dass der Messwert CII des Sensors S1 derart kleiner als der Messwert C12 des Sensors S2 ist, dass die Beziehung

$$C11 < C_{T1} = \frac{V_T}{V - V_T} * C12$$

erfüllt ist, wenn sich keine Flüssigkeit im Behälter 11 befindet. Befindet sich im Behälter 11 bis zu einer Höhe h Flüssigkeit, die über dem Niveau N1 und unter dem Niveau N2 liegt, dann soll der Messwert C11 des Sensors S1 grösser als der Wert $C_{T1}$ sein. Ist schliesslich der Behälter 11 über das Niveau N2 hinaus mit Flüssigkeit gefüllt, dann erfüllen die Messwerte C11 und C12 wiederum die Beziehung $C11 < C_{T1}$.

Der Ausgang A der Schaltungsanordnung 9 führt somit ein wechselförmiges Signal $U_A(t)$, falls sich im Behälter 11 Flüssigkeit bis zu einer Höhe h befindet, die zwischen den beiden Niveaus N1 und N2 liegt, andernfalls führt der Ausgang A das konstante Potential $V_T$.

Die Schaltungsanordnungen 1 (Figur 1) und 8 (Figur 5) offenbaren ein Messprinzip, das auf dem Vergleich zweier Zeitkonstanten beruht, die durch RC und LR Glieder bestimmt sind. Sie eignen sich deshalb gleichermassen für resistive, kapazitive und induktive Sensoren. Die Schaltungsanordnung 9 (Figur 6) hingegen beruht auf dem direkten Vergleich der Werte von zwei kapazitiven Elementen.

Bei induktiven Sensoren ist es in der Regel bevorzugt, als Referenzelement ein kapazitives Element einzusetzen, da Kondensatoren platzsparender und billiger sind.

**Patentansprüche**

1. Schaltungsanordnung (1; 6; 8) mit einem zweipoligen kapazitiven, induktiven oder resistiven, als Sensor dienenden Element (C1; C2; L2; R1; R2; R3), die zum Erfassen des Überschreitens oder Unterschreitens eines vorbestimmten Schwellwertes des zweipoligen Elementes dient, mit einem Ausgang (A), **dadurch gekennzeichnet**, dass die Schaltungsanordnung (1; 6; 8) ein erstes, eine erste Zeitkonstante $\tau$1 bestimmendes Schaltungsteil (R1, C1), ein zweites, eine zweite Zeitkonstante $\tau$2 bestimmendes Schaltungsteil (R2, R3, C2; R2, R3, L2) und ein drittes, aus einer Spannungsquelle gegenüber einem Bezugspotential (m) speisbares Schaltungsteil (2) umfasst, wobei das zweipolige Element (C1; C2; L2; R1; R2; R3) entweder ein Bauteil des ersten oder des zweiten Schaltungsteils ist und daher entweder die Zeitkonstante $\tau$1 oder die Zeitkonstante $\tau$2 zu ändern vermag und wobei die Parameter der anderen Bauteile des ersten und zweiten Schaltungsteils den Schwellwert bestimmen, und dass die Zeitkonstanten $\tau$1 und $\tau$2 die Schwingfähigkeit der Schaltungsanordnung mitbestimmen, so dass die Spannung $U_A(t)$ am Ausgang (A) beim Überschreiten oder Unterschreiten des Schwellwertes von einer wechselförmigen auf eine gleichförmige Form, oder umgekehrt, wechselt.

2. Schaltungsanordnung (1; 6; 8) nach Anspruch 1, **dadurch gekennzeichnet,** dass die die Zeitkonstanten $\tau$1 und $\tau$2 bestimmenden Schaltungsteile je ein aus einem kapazitiven Element und einem Widerstand gebildetes RC-Glied oder ein aus einem Widerstand und einer Induktivität gebildetes LR-Glied ist.

3. Schaltungsanordnung (1; 6) nach Anspruch 1 oder 2, **dadurch gekennzeichnet,** dass das dritte Schaltungsteil (2) zum Vergleich der Zeitkonstanten $\tau$1 und $\tau$2 ein Komparator (2) mit zwei Eingängen (3; 4) und einem Ausgang ist, wobei der Ausgang des Komparators (2) den Ausgang (A) der Schaltungsanordnung darstellt, und dass der Ausgang des Komparators (2) einerseits über das erste Schaltungsteil (R1, C1) mit dem einen Eingang (3) und weiter mit dem Bezugspotential (m) und andererseits über das zweite Schaltungsteil (R2, R3, C2; R2, R3, L2) mit dem anderen Eingang (4) und dem Bezugspotential (m) verbunden ist.

4. Schaltungsanordnung nach einem der Ansprüche 1 bis 3, **dadurch gekennzeichnet,** dass wenigstens ein Widerstand (R1, R2) durch eine gesteuerte Stromquelle ersetzt ist.

5. Schaltungsanordnung (8) nach Anspruch 1 oder 2, **dadurch gekennzeichnet,** dass das Schaltungsteil (2) zum Vergleich der Zeitkonstanten $\tau$1 und $\tau$2 zwei Transistoren (T1, T2) umfasst und dass die Basis des zweiten Transistors (T2) mit dem Emitter oder Kollektor des ersten Transistors (T1) gekoppelt ist.

6. Schaltungsanordnung (1; 6; 8) nach einem der Ansprüche 1 bis 5, **dadurch gekennzeichnet,** dass das erste und das zweite Schaltungsteil entweder beide ein kapazitives oder beide ein induktives Element enthalten, die beide als Sensor dienen, dass das erste und das zweite Schaltungsteil je wenigstens einen Widerstand enthalten, und dass die Widerstände so vorbestimmt sind, dass kleine Differenzen der zu messenden physikalischen Grösse grosse Änderungen der Frequenz der Schwingungen verursachen.

7. Schaltungsanordnung (9) zum Betrieb eines kapazitiven Elementes (C11; C12), das als Sensor zum Erfassen des Überschreitens oder Unterschreitens eines vorbestimmten Schwellwertes dient, mit einem Ausgang (A), **dadurch gekennzeichnet,** dass die Schaltungsanordnung (9) zwei in Reihe geschaltete Inverter (I1, I2) aufweist, wobei der Ausgang des zweiten Inverters (I2) den Ausgang (A) der Schaltungsanordnung (9) darstellt, dass der Ausgang des zweiten Inverters (I2) über ein erstes kapazitives Element (C11) mit dem Eingang des ersten Inverters (I1) verbunden ist, dass der Ausgang und der Eingang des ersten Inverters (I1) über einen Widerstand (R11) verbunden sind, dass der Ausgang und der Eingang des ersten Inverters (I1) über ein zweites kapazitives Element (C12) verbunden sind und dass wenigstens eines der beiden kapazitiven Elemente (C11, C12) ein Sensor ist.

8. Schaltungsanordnung (10) zum Betrieb eines Widerstandes (R11; R12), der als Sensor zum Erfassen des Überschreitens oder Unterschreitens eines vorbestimmten Schwellwertes dient, mit einem Ausgang (A), **dadurch gekennzeichnet,** dass die Schaltungsanordnung (10) zwei in Reihe geschaltete Inverter (I1, I2) aufweist, wobei der Ausgang des zweiten Inverters (I2) den Ausgang (A) der Schaltungsanordnung (10) darstellt, dass der Ausgang des zweiten Inverters (I2) über ein kapazitives Element (C11) mit dem Eingang des ersten Inverters (I1) verbunden ist, dass der Ausgang und der Eingang des ersten Inverters (I1) über einen ersten Widerstand (R11) verbunden sind, dass der Ausgang des zweiten Inverters (I2) und der Eingang des ersten Inverters (I1) über einen zweiten Widerstand (R12) verbunden sind und dass wenigstens einer der beiden Widerstände (R11, R12) ein Sensor ist.

9. Schaltungsanordnung zum Betrieb eines resistiven oder kapazitiven Elementes, das als Sensor zum Erfassen des Überschreitens oder Unterschreitens eines vorbestimmten Schwellwertes dient, mit einem Ausgang (A), **dadurch gekennzeichnet,** dass die Schaltungsanordnung zwei in Reihe geschaltete Inverter (I1, I2) aufweist, wobei der Ausgang des zweiten Inverters (I2) den Ausgang (A) der Schaltungsanordnung darstellt, dass der Ausgang des zweiten Inverters (I2) über ein kapazitives Element (C11) mit dem Eingang des ersten Inverters (I1) verbunden ist, dass der Ausgang und der Eingang des ersten Inverters (I1) über einen Widerstand (R11) verbunden sind, dass der Ausgang und der Eingang des ersten Inverters (I1) über ein weiteres kapazitives Element (C12) verbunden sind und dass der Ausgang des zweiten Inverters (I2) und der Eingang des ersten Inverters (I1) über einen weiteren Widerstand (R12) verbunden sind, und dass wenigstens eines der kapazitiven Elemente (C11, C12) oder der Widerstände (R11, R12) ein Sensor ist.

10. Schaltungsanordnung nach einem der Ansprüche 1 bis 5, 7 oder 9, **dadurch gekennzeichnet,** dass beide kapazitiven Elemente (C1, C2; C11, C12) als Sensoren zur Erfassung eines unteren und eines oberen Niveaus (N1, N2) eines Flüssigkeitsbehälters (11) vorgesehen sind.

**Fig. 1**

**Fig. 2**

Fig. 3

R 1

_6_

3

2

4

A

L 2

R 2

B

_5_

R 3

C1

m

Fig. 4

1

D

A 2

A

C3

R 5

m

Fig. 5

Vcc

_8_

R6

R 7

R 9

T 1

T 2

R 8a

C 4

C 5

R 8b

m

Fig. 6

_9_

I1   R   I2   C11

C12

A

Fig. 7

P2

C11

P3

C12

R11

P1

Fig. 8

$u_3$

$V_T$

t

Fig. 9

R11

C11

_10_

R12

I1   I2

Fig. 10

N2 — — — — — — — S2

11

h

N1 — — — — — — — S1

12

**Europäisches Patentamt**

# EUROPÄISCHER RECHERCHENBERICHT

Nummer der Anmeldung

EP 96 81 0335

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.6) |
|---|---|---|---|
| X | WO-A-95 04261 (ZATLER ANDREJ ;EFERL FRANC (SI)) 9.Februar 1995<br>* Seite 1, Zeile 8 - Zeile 15 *<br>* Seite 6, Zeile 20 - Seite 7, Zeile 22 *<br>* Abbildungen *<br>--- | 1-3,10 | H03K17/94 |
| X | DE-A-42 38 992 (IFM ELECTRONIC GMBH) 26.Mai 1994<br>* Spalte 3, Zeile 68 - Spalte 5, Zeile 14; Abbildung 2 *<br>--- | 1-3 | |
| A | DE-C-34 23 132 (ERDMANN, HANS) 23.Januar 1986<br>* Spalte 4, Zeile 55 - Spalte 5, Zeile 37; Abbildung 2 *<br>--- | 1,2 | |
| A | DE-A-26 44 714 (WICKMAN MACH TOOL SALES LTD) 14.April 1977<br>* Seite 7, Zeile 1 - Zeile 34; Abbildung 1 *<br>--- | 5 | |
| X | PATENT ABSTRACTS OF JAPAN<br>vol. 011, no. 126 (P-569), 21.April 1987<br>& JP-A-61 270611 (MATSUSHITA ELECTRIC WORKS LTD), 29.November 1986,<br>* Zusammenfassung *<br>--- | 7 | **RECHERCHIERTE SACHGEBIETE (Int.Cl.6)**<br><br>H03K |
| X | PATENT ABSTRACTS OF JAPAN<br>vol. 013, no. 160 (E-744), 18.April 1989<br>& JP-A-63 314912 (HOKURIKU DENKI KOGYO KK), 22.Dezember 1988,<br>* Zusammenfassung *<br>--- | 8,9 | |
| A | US-A-4 240 528 (KRAUS HANS) 23.Dezember 1980<br>* Zusammenfassung; Abbildungen 5,9 *<br>----- | 10 | |

Der vorliegende Recherchenbericht wurde für alle Patentansprüche erstellt

| Recherchenort | Abschlußdatum der Recherche | Prüfer |
|---|---|---|
| DEN HAAG | 30.August 1996 | D/L PINTA BALLE.., L |